# EUROPEAN PATENT APPLICATION

(11) **EP 3 764 758 A1**
(43) Date of publication of application: **13.01.2021**
(21) Application number: 19186068.3
(22) Date of filing: 12.07.2019
(51) Int. Cl.: H05K 3/34, H01R 12/71, H05K 3/40

(54) **PRINTED CIRCUIT BOARD WITH SOLDERED CONDUCTIVE ELEMENT**

(71) Applicant: Verisure Sàrl, 1290 Versoix (CH)
(72) Inventor: Mårtensson, Henrik, 1290 Versoix Geneva (CH)
(74) Representative: Prinz & Partner mbB

(57) **Abstract**

The invention relates to a printed circuit board (2) having at least one contact pad (6) and a conductive element (10; 100) connected to the contact pad (6) in an electrically conductive manner, the conductive element (10; 100) having a soldering wing (12), the soldering wing (12) having a flat soldering surface (12S) and an engagement projection (16) which engages into an opening (7) provided in the printed circuit board (2) and associated with the contact pad (6), the engagement projection (16) being cylindrical and having an insertion radius (R) at its end remote from the soldering wing (12), a solder connection being established between the contact pad (6) and the soldering wing (12) as well as between the inner surface of the opening (7) in the printed circuit board (2) and the outer surface of the engagement projection (16).

## Description

The invention relates to a printed circuit board having at least conductive element soldered thereto.

The printed circuit board is part of an electronic device can be battery-powered and/or be adapted for communicating with other units. Examples for such device are a remote control, a sensor, a communication interface and a smart lock.

Taking a battery contact as an example for the conductive element soldered to a printed circuit board, it has one or two very thin contact pins which are placed in associated openings of the printed circuit board (PCB). As there is a high risk that the contact pins are being bent or damaged during the mounting process, the battery contacts are often mounted manually, followed by a soldering process. This results in increased costs per unit. Should the battery contacts be mounted and soldered automatically, then there is a high risk of a certain percentage of the battery contacts is not being mounted properly, resulting in a high scrap rate. This is particularly problematic as the PCB, at this stage of the manufacturing process, is already equipped with its electronic components.

Taking an antenna as an example for the conductive element soldered to the printed circuit board, similar problems exist in the prior art. It is not easy to mount the antenna in an automated manner.

The object of the invention is to provide a PCB having a conductive element which can be mounted to the PCB in an automated manner, in particular by using a robot and/or by using a SMT solder process.

To this end, the invention provides a printed circuit board having at least one contact pad (6) and a conductive element connected to the contact pad (6) in an electrically conductive manner, the conductive element having a soldering wing, the soldering wing having a flat soldering surface and an engagement projection which engages into an opening provided in the printed circuit board and associated with the contact pad, the engagement projection being cylindrical and having an insertion radius at its end remote from the soldering wing, a solder connection being established between the contact pad and the soldering wing as well as between the inner surface of the opening in the printed circuit board and the outer surface of the engagement projection.

The invention is based on the concept of using an engagement projection which on the one hand is mechanically strong as it is a cylindrical structure, thereby preventing unwanted deformation of the engagement projection, and on the other hand facilitates the step of placing the engagement projection in the associated opening in the PCB as it has the insertion radius which assists aligning the engagement projection with the opening should there be a slight offset. Thus, the conductive element can be mounted with a robot, resulting in low manufacturing costs and allowing the entire PCB to be soldered in one step.

According to a preferred embodiment, the engagement projection has a bottom wall at its end remote from the soldering wing. The bottom wall, on the one hand, serves for increased rigidity. On the other hand, the bottom wall closes the engagement projection so that a the conductive element can be gripped by placing a suction cup on the soldering wing on its side opposite the engagement projection and then applying a vacuum.

The engagement projection can have a circular cross section which results in the solder connection being established around the entire surface of the engagement projection.

In an alternative design, the engagement projection can have an elliptical cross section. This cross section can be used for establishing a press fit connection between the outer portions of the engagement projections arranged along the longer radius of the elliptical cross section and the inner surface of the opening in the PCB while leaving enough space for the soldering material in the regions of the smaller radius of the elliptical cross section. As an alternative to creating a press-fit, an elliptical opening in the PCB can be used so that a gap is created which extends around the engagement projection, allowing to rotationally lock the conductive element in the opening.

According to a preferred embodiment, the opening in the PCB is in the center of the contact pad, resulting in a design which requires very little space on the PCB.

In one embodiment, the conductive element is a contact element for supplying electric energy to a circuit arranged on the printed circuit board, the contact element having a contact wing connected to the soldering wing. As the soldering connection established between the inner surface of the opening in the PCB and the outer surface of the engagement projection can withstand high loads, the contact element can withstand the mechanical forces resulting from a battery or a battery holder being pressed against the contact element.

According to an embodiment, the contact wing extends along an outer edge of the printed circuit board and has at least one abutment arranged in the vicinity of the outer edge of the printed circuit board. Should high loads be placed on the contact wing, it is slightly deflected towards the PCB until the abutment comes to a rest on the outer edge of the printed circuit board. In this condition, additional loads are directly transferred from the contact wing via the abutment to the printed circuit board, limiting the load which acts on the soldering connection.

The abutment preferably is, when viewed laterally, in the shape of a wedge which merges into the contact wing at its side remote from the soldering wing. As the contact wing typically extends beyond the underside of the printed circuit board (assuming that the soldering wing is placed on the upper side), there initially during the mounting process is a large lateral distance between the outer edge of the PCB and the contact wing, this distance gradually decreasing when the engagement projection is being pushed into the opening of the PCB.

According to an embodiment, the abutment is formed from an edge portion of the contact wing which is offset from the central portion of the contact wing. In other words, the abutment is formed from a stamped or otherwise plastically deformed portion of the contact wing.

Preferably, two abutments are provided on either side of a centrally arranged contact protrusion formed in the contact wing. This prevents torsional loads being placed on the contact wing when force is exerted onto the contact wing via the centrally arranged contact protrusion.

Should the contact element have a single engagement projection instead of typically two engagement pins as in the prior art, the particular angular orientation of the engagement projection is irrelevant for moving the cylindrical engagement projection into the associated opening, even though the contact element, in the finally mounted condition, should have a predefined orientation.

According to an alternative embodiment, the contact wing extends away from the printed circuit board and carries a contact spring. The contact spring can be used for connecting the negative pole of a battery.

Preferably, a suction wing is provided at the contact wing. This suction wing allows to mount the contact element with a robot as in this particular embodiment, the contact spring prevents placing a suction cup on the suction wing.

According to another embodiment, the soldering wing is circular. Thus, a round metal pole or contact is achieved which can be used if there is a need for a contact surface for vertical attachment. The metal pole is much more durable than a normal plated pad on a PCB which can get scratched.

According to yet another embodiment, the conductive element is an antenna. The engagement projection provided at the soldering wing allows mounting the antenna with little effort to the PCB.

When the antenna has two spaced engagement projections and a spacer element, it can be placed on the PCB in a mechanically stable position.

Preferably, the center of gravity of the conductive element is, when placed on the printed circuit board extending in a horizontal direction, inwardly of the outer edge of the printed circuit board, making it possible to freely place the conductive element on the PCB for mounting. Further, the engagement of the projection into the opening helps keeping the conductive element in its position. Finally, the presence of the solder past (which is sticky before soldering) also helps keeping the conductive element in the mounted position. No additional jigs or fastening elements are necessary.

Preferably, the conductive element is a stamped part formed from sheet metal. This allows forming the entire conductive element including the engagement projection as a unitary element. The engagement projection can be deep-drawn.

For forming the conductive element, sheet metal with a small thickness in the range of 0.2 mm to 0.4 mm can be used.

For achieving a sufficient rigidity and stability of the engagement projection, it is sufficient for the engagement projection to have a diameter between 1.5 and 3 millimeters.

In order to increase the stability of the solder connection even further, the solder connection comprises a ring of solder material extending around the free end of the engagement projection and to the printed circuit board. As a result, the solder connection consists of a flat solder plate extending between the soldering wing and the PCB, of a cylindrical soldering ring extending around the engagement projection, and of a soldering ring arranged at the side of the PCB which is opposite the side where the soldering wing is placed.

The invention will now be described with reference to the enclosed drawings. In the drawings,
Figure 1 shows in a perspective, sectioned view part of a printed circuit board equipped with two conductive elements which form contact elements;
Figure 2 shows in a perspective view a printed circuit board with a mounted contact element and with a contact element which is about to be mounted at the printed circuit board;
Figure 3 shows one of the contact elements of Figure 2 in a first perspective view;
Figure 4 shows the contact element of Figure 3 in a second perspective view;
Figure 5 shows a top view of a contact element mounted at the printed circuit board;
Figure 6 shows a side view of a contact element placed at a printed circuit board which is shown in a cross section;
Figure 7 shows an alternative embodiment of the contact element in a perspective view;
Figure 8 shows an alternative embodiment of the conductive element; and
Figure 9 shows yet another embodiment of the conductive element.

In the drawings, reference numeral 2 designates a printed circuit board which is a well-known component in electronic devices. PCB 2 can here be part of any device which is battery-powered, for example a remote control, a communication interface or a sensor, in particular as part of an alarm installation which is adapted for detecting unwanted intrusion into an apartment, a house or similar premises.

The sensor can be a glass breakage sensor or a shock sensor, and the communication interface can serve for arming or disarming the alarm system or for receiving and transmitting speech and/or video signals to and from a control unit.

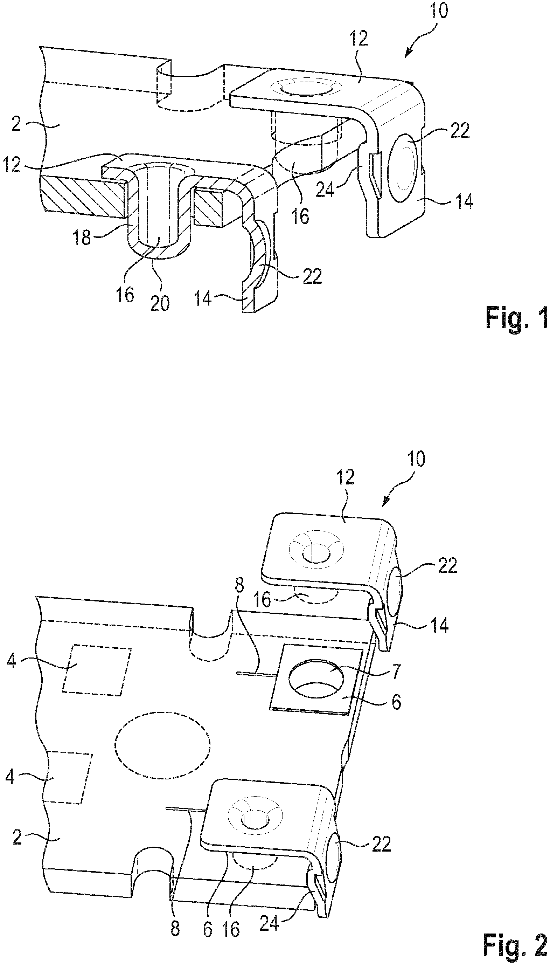

On the PCB, very various electronic components are arranged which are of no relevance here and which are only very schematically shown with reference numeral 4 in Figure 2.

PCB 2 is provided with two contact pads 6 (of which only one is visible in Figure 2), the contact pads 6 serving for providing electric energy to electronic components 4 via schematically shown conductor lines 8.

Printed circuit board 2 is provided with an opening 7 which extends through the entire printed circuit board and is here arranged in the center of contact pad 6. As can be seen in Figure 2, opening 7 has a circular cross section.

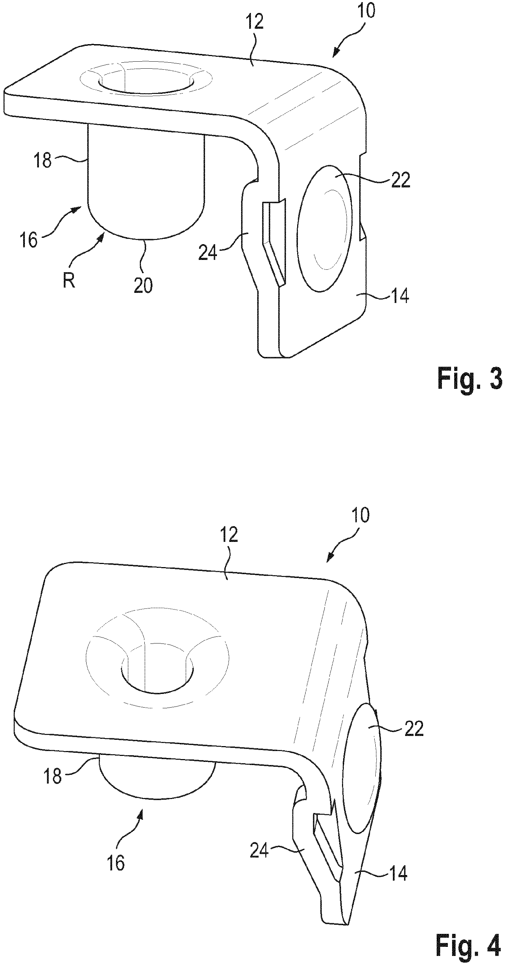

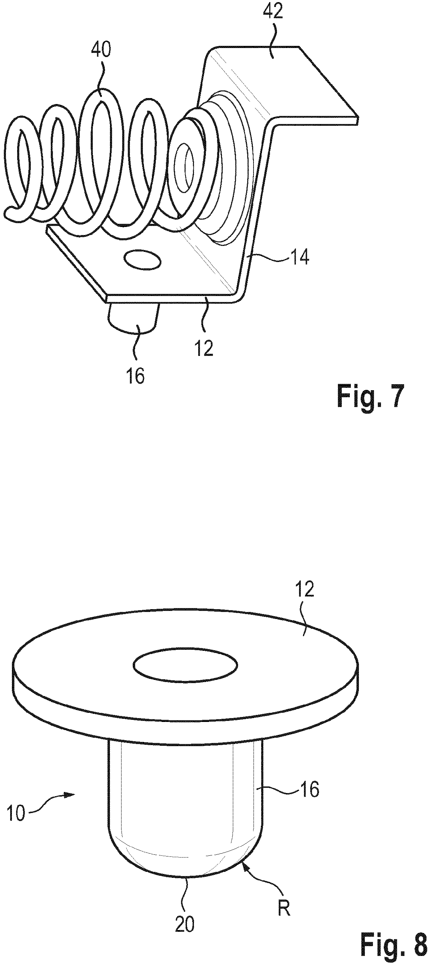

For connecting conductor pads 6 with a battery, conductive elements 10 are provided which here form contact elements 10 or battery contacts (please see in particular Figures 3 and 4 for a first embodiment and Figure 7 for a second embodiment). In the following, reference will first be made to the embodiment shown in Figures 1 to 6.

Each contact element 10 comprises a soldering wing 12 and a contact wing 14. Soldering wing 12 serves for being soldered to contact pad 6, and contact wing 14 serves for being connected (directly or indirectly) to a battery.

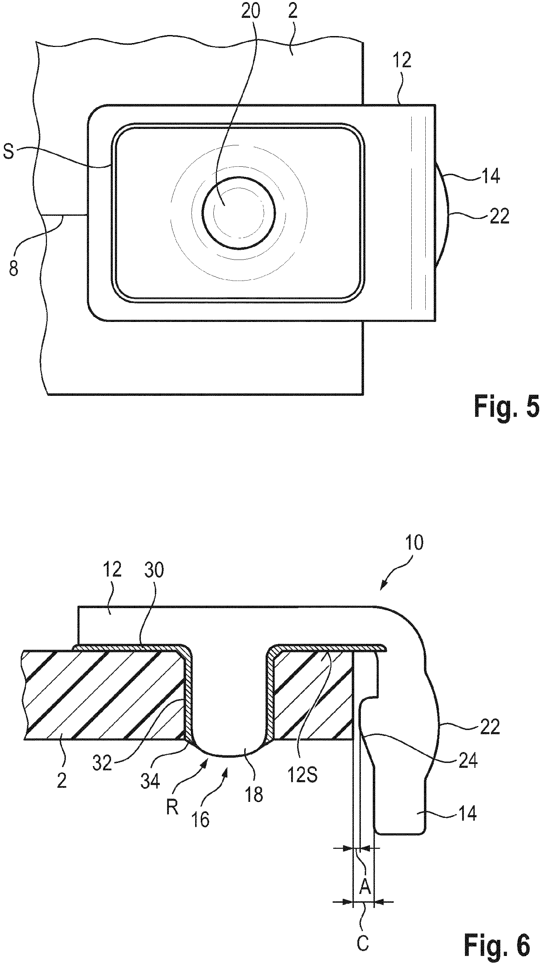

Soldering wing 12 has in a top view a generally rectangular form (please see in particular Figure 5) and is provided with an engagement projection 16. The engagement projection 16 is formed by deep-drawing the material provided in soldering wing 12 and thus has a hollow shape with side walls 18 and a bottom wall 20.

Engagement projection 16 has the shape of a hollow cylinder. In the embodiment shown, a cross section in a plane perpendicular to the center axis of engagement projection 16 is circular.

At the transition between side walls 18 and bottom wall 20, a large radius R is formed.

Contact wing 14 has a centrally arranged contact protrusion 22 and two abutments 24 on either side of contact protrusion 22.

Abutment 24 (please see in particular Figures 3 and 4) is formed as a portion of the outer edge of contact wing 14 which is offset, towards engagement projection 16, with respect to the remaining portion of contact wing 14.

As can be seen in particular in Figures 3, 4 and 6, abutment 24 has a wedge shape or the shape of a ramp, with the "higher" portion of the ramp being on the side where contact wing 14 merges into soldering wing 12, with the ramp merging into contact wing 14 on its side which is facing away from soldering wing 12.

Contact element 10 is formed in a single piece from a stamped portion of sheet metal. This portion is rectangular so that both the soldering wing and the contact wing can be formed, and it can be plastically deformed so as to allow stamping of engagement projection 16 and of abutments 24.

Generally, any electrically conductive material which can be sufficiently plastically deformed is suitable for contact element 10. One example of a suitable material is bronze.

In a mounted condition, each contact element 10 is mounted to printed circuit board 2 so that engagement projection 16 is arranged within opening 7, with soldering wing 12 being placed on contact pad 6 so that the flat "underside" of soldering wing 12 serves as a soldering surface 12S to be connected with contact pad 6.

For mounting the contact elements 10, a robot can be used which is equipped with a suction pad, the suction pad engaging the contact elements on the surface of soldering wing 12 which is opposite the side at which the engagement projection 16 extends. This area is marked in Figure 5 with a line to which reference numeral S points. The presence of hollow engagement projection 16 is no obstacle in gripping contact elements 10 by applying a vacuum as engagement projection 16 is closed because of bottom wall 20.

Before placing contact elements 10 on printed circuit board 2, a soldering material is arranged on contact pad 6 and/or on soldering wing 12 of contact element 10. The soldering material can be applied in any suitable form.

In the process of mounting the contact elements 10, they are advanced towards printed circuit board 2 from above (please see Figure 2 with the arrow marking the direction in which contact element 10 is moved towards printed circuit board 2). It is not necessary that contact wing 14 is aligned perfectly parallel to the adjacent outer edge of the printed circuit board as there is some clearance between the edge of printed circuit board 2 and the inner surface of contact wing 14. This clearance is designated in Figure 6 with reference numeral C.

The large radius R at the free end of engagement projection 16 facilitates its insertion into opening 7, resulting in contact element 10 being correctly positioned on PCB 2.

Also the ramp shape of abutment 24 facilitates the placement of contact element 10 in the correct position. At the beginning of the mounting process, there is a maximum clearance C (please see Figure 6) between the inner side of contact wing 14 and the outer edge of PCB 2. During the insertion, this distance is decreasing gradually until there is a remaining minimum distance A.

When the contact elements 10 are placed on the printed circuit board 2, it is not necessary to mechanically fix them in their position as the center of gravity of each of the contact elements is arranged "inwardly" of the outer edge of printed circuit board 2. Accordingly, the contact elements remain in their position under the influence of gravity.

In an alternative design, engagement projection 16 might engage into opening 7 with a slight press fit so that contact element 10 remains in the mounted position even if there are vibrations or other disturbances. Such press fit might be obtained by using an engagement projection which has an elliptical cross section.

When the contact elements are placed at the printed circuit board, all elements on the printed circuit board (including the electronic components) can be soldered to the printed circuit board. As a result, the contact elements 10 are connected to the printed circuit board 2 by means of a solder connection which here consists of three elements: A flat, plate-like portion 30; a cylindrical portion 32 and a ring-shaped portion 34. The flat, plate-like portion 30 extends between contact pad 6 and the lower surface of soldering wing 12, this surface acting as a flat soldering surface 12S. The cylindrical portion 32 connects the outer surface of side wall 18 of engagement projection 16 to the inner wall of opening 7. The ring-shaped portion 34 has a triangular cross section and connects the lower surface of printed circuit board 2 with the transition between side wall 18 and bottom wall 20 of engagement projection 16. Accordingly, a very large solder connection is established between soldering wing 12 and printed circuit board 2.

The thus established soldering connection is able to withstand high loads which might act on contact wing 14 and have to be transferred to printed circuit board 2. In order to limit the loads which might act on the soldering connection, abutment 24 is arranged such that the distance A (please see Figure 6) from the outer edge of printed circuit board 2 is quite small. Should contact wing 14 be deflected towards printed circuit board 2 by a distance which is equal to distance A, abutment 24 contacts the outer edge of the printed circuit board so that any additional loads are directly transferred from the contact wing 14 into the printed circuit board 2 without acting on the soldering connection.

In the embodiment shown in Figures 1 to 6, two identical contact elements 10 are used. This is due to the fact that they are adapted for contacting two associated contacts of a battery holder instead of contacting the batteries directly. In the embodiment of Figure 7, a contact element 10 is shown which is intended to directly contact the negative pole of a battery. For the elements known from the previous embodiment, the same reference numerals are used, and reference is made to the above comments.

The difference between the contact element shown in Figure 7 and the contact elements of the previous embodiment are that contact wing 14 in the embodiment of Figure 7 does not extend along the outer edge of printed circuit board 2 but is placed above the printed circuit board and extends upwardly therefrom. Further, it is provided with a contact spring 40.

As the upper surface of soldering wing 12 is not accessible for a suction cup, a suction pad 42 is provided on contact element 10. It extends from the end of contact wing 14 which is remote from soldering wing 12, and approximately in parallel with soldering wing 12. Accordingly, it can be easily gripped by a suction cup of a robot so as to allow mounting the contact element in an automated manner.

For this embodiment as well, the center of gravity is located "rearwardly" of the outer edge of the printed circuit board so that contact element 10 rests under the influence of gravity in a mounted position.

In Figure 8, another example of a conductive element 10 is shown, the conductive element here forming a circular contact element 10. For the elements known from the previous embodiments, the same reference numerals are used, the reference is made to the above comments.

Contact element 10 shown in Figure 8 has circular soldering wing 12 which is provided in its center with engagement projection 16., a round metal pole or contact is achieved which can be used as a contact surface for vertical attachment. The metal pole is much more durable than a normal plated pad on a PCB which can get scratched.

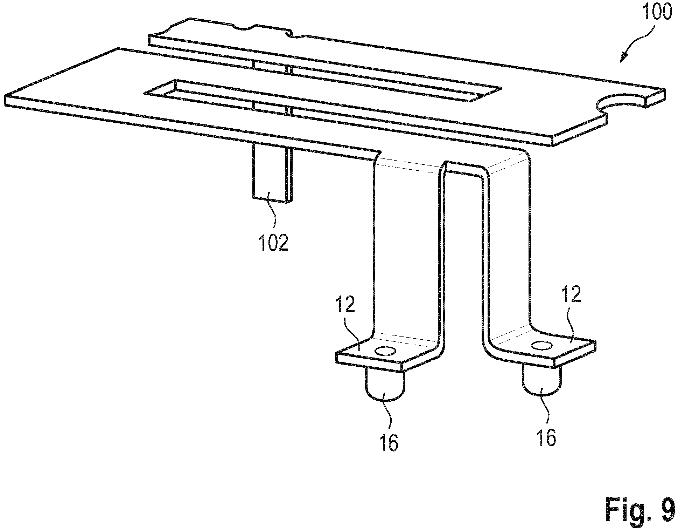

In Figure 9, another example of a conductive element is shown, with the conductive element 100 here forming a sheet metal antenna. For the elements known from the previous embodiments, the same reference numerals are used, the reference is made to the above comments.

Antenna 100 has two soldering wings 12 each provided with an engagement projection 16. One of the soldering wings can be used as a feed contact, and the other one can be used as a shorting pin. Further, a spacer element 102 is provide which is a support for the antenna structure.

The center of gravity of antenna 100 is such that it remains in its mounted position so that it can be soldered.

## Claims

1. Printed circuit board (2) having at least one contact pad (6) and a conductive element (10; 100) connected to the contact pad (6) in an electrically conductive manner, the conductive element (10; 100) having a soldering wing (12), the soldering wing (12) having a flat soldering surface (12S) and an engagement projection (16) which engages into an opening (7) provided in the printed circuit board (2) and associated with the contact pad (6), the engagement projection (16) being cylindrical and having an insertion radius (R) at its end remote from the soldering wing (12), a solder connection being established between the contact pad (6) and the soldering wing (12) as well as between the inner surface of the opening (7) in the printed circuit board (2) and the outer surface of the engagement projection (16).

2. The printed circuit board of claim 1 wherein the engagement projection (16) has a bottom wall (20) at its end remote from the soldering wing (12).

3. The printed circuit board of any of the preceding claims wherein the engagement projection (16) has a circular cross-section.

4. The printed circuit board of any of claims 1 and 2 wherein the engagement projection (16) has an elliptical or any other deep-drawn cross-section.

5. The printed circuit board of any of the preceding claims wherein the opening (7) is in the center of the contact pad (6).

6. The printed circuit board of any of the preceding claims wherein the conductive element (10) is a contact element for supplying electric energy to a circuit arranged on the printed circuit board (2), the contact element (10) having a contact wing (14) connected to the soldering wing (12).

7. The printed circuit board of claim 6 wherein the contact wing (14) extends along an outer edge of the printed circuit board (2) and has at least one abutment (24) arranged in the vicinity of the outer edge of the printed circuit board (2).

8. The printed circuit board of claim 7 wherein the abutment (24) is, when viewed laterally, in the shape of a wedge which merges into the contact wing (14) at its side remote from the soldering wing (12).

9. The printed circuit board of claim 7 or claim 8 wherein the abutment (24) is formed from an edge portion of the contact wing (14) which is offset from the central portion of the contact wing (14).

10. The printed circuit board of claim 9 wherein two abutments (24) are provided on either side of a centrally arranged contact protrusion (22) formed in the contact wing (14).

11. The printed circuit board of claim 6 wherein the contact wing (14) extends away from the printed circuit board (2) and carries a contact spring (40).

12. The printed circuit board of claim 11 wherein a suction wing (42) is provided at the contact wing (14).

13. The printed circuit board of any of claim 1 to 5 wherein the soldering wing (12) is circular.

14. The printed circuit board of any of claims 1 to 5 wherein the conductive element is an antenna (100).

15. The printed circuit board of claim 14 wherein the antenna has two spaced engagement projections (16) and a spacer element (102).

16. The printed circuit board of any of the preceding claims wherein the center of gravity of the conductive element (10; 100) is, when placed on the printed circuit board (2) extending in a horizontal direction, inwardly of the outer edge of the printed circuit board (2).

17. The printed circuit board of any of the preceding claims wherein the conductive element (10; 100) is a stamped part formed from sheet metal.

18. The printed circuit board of claim 13 wherein the sheet metal has a thickness of approx. 0.2 mm.

19. The printed circuit board of any of the preceding claims wherein the diameter of the engagement projection (16) is between 2 and 3 mm.

20. The printed circuit board of any of the preceding claims wherein the solder connection comprises a ring-shaped ring (34) of solder material extending around the free end of the engagement projection (16) and to the printed circuit board (2).
